# EUROPEAN PATENT APPLICATION

(11) **EP 4 576 997 A1**
(43) Date of publication of application: **25.06.2025**
(21) Application number: 24214489.7
(22) Date of filing: 21.11.2024
(51) Int. Cl.: H10D 84/01, H01L 21/768, H01L 23/48, H10D 84/40, H10D 88/00, H01L 23/528, H01L 25/065

(54) **SEMICONDUCTOR DIES HAVING BACKSIDE POWER SWITCH COMPONENTS AND RELATED METHODS**

(30) Priority: 22.12.2023 US 202318394803
(71) Applicant: INTEL Corporation, Santa Clara, CA 95054 (US)
(72) Inventor: KRENNER, Wolfgang Benedikt, 82069 Hohenschaeftlarn (DE); KREBS, Tim Helmut, 81475 Munich (DE); SCHMIDT, Martin, 81369 Munich (DE)
(74) Representative: HGF

(57) **Abstract**

Semiconductor dies having backside power switch components and related methods are disclosed herein. An example semiconductor die includes a semiconductor substrate defining a front side and a backside. A signal network is provided on the front side. The signal network includes a plurality of first transistors. A power delivery network is provided on the backside. The power delivery network includes a power switch provided on the backside. The power switch includes a plurality of second transistors. The power switch is to cause operation of the first transistors to switch between a first operating state and a second operating state.

## Description

### FIELD OF THE DISCLOSURE

This disclosure relates generally to integrated circuit packages and, more particularly, to semiconductor dies having backside power switch components and related methods.

### BACKGROUND

Integrated circuit (IC) chips and/or semiconductor dies have exhibited reductions in size and increases in interconnect densities as technology has advanced.

### BRIEF DESCRIPTION OF THE DRAWINGS

FIG. 1A is a front view of an example integrated circuit (IC) package constructed in accordance with teachings of this disclosure.
FIG. 1B is a top view of the example IC package of FIG. 1A.
FIG. 2 is a cross-sectional view of an example semiconductor die of FIGS. 1A and 1B.
FIG. 3A is a schematic illustration of an example implementation of the example semiconductor die of FIGS. 1A, 1B and/or 2.
FIG. 3B is a schematic illustration of another example implementation of the example semiconductor die of FIGS. 1A, 1B and/or 2.
FIG. 4 illustrates an example method of fabricating an example semiconductor die.
FIG. 5 is a top view of a wafer including dies that may be included in an IC package constructed in accordance with teachings disclosed herein.
FIG. 6 is a cross-sectional side view of an IC device that may be included in an IC package constructed in accordance with teachings disclosed herein.
FIG. 7 is a cross-sectional side view of an IC device assembly that may include an IC package constructed in accordance with teachings disclosed herein.
FIG. 8 is a block diagram of an example electrical device that may include an IC package constructed in accordance with teachings disclosed herein.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all these lines and/or boundaries may be idealized. In reality, the boundaries and/or lines may be unobservable, blended, and/or irregular.

### DETAILED DESCRIPTION

Integrated circuit (IC) packages include multiple layers of materials that form transistors and/or interconnects for providing power and/or signal processing. For example, integrated circuits (ICs) such as microprocessors, field programmable gate arrays, memory devices, and other application-specific ICs contain transistors. Transistors are multi-terminal switches that can be turned on or off on the basis of a control signal. The on or off state of the transistor determines whether current flows through the device. In complementary metal oxide semiconductor (CMOS) field effect transistor (MOSFET) technology (which is the most popular technology used to design microprocessors at present), two types of transistors are used, namely an n-channel (NMOS) transistor and a p-channel (PMOS) transistor. The IC packages include interconnects to power the transistors or transmit data signals.

To control the state(s) of the transistors, integrated circuits employ power delivery networks (PDNs) that include switching circuits to control the transistors (e.g., between the on and off states). As miniaturization progresses and more transistors are integrated into an integrated circuit, power and current levels are expected to increase. In addition, electromagnetic interference levels should be kept low in the system to manage coupling and crosstalk.

To improve power delivery and/or signal processing, some IC packages employ a backside power delivery configuration. Typically, IC packages having backside power delivery configurations include backside metal routing and frontside metal routing that surround transistors. For instance, in advanced silicon (Si) process technologies instead of employing front side metal layers that are shared with signal routing resources, a power delivery network (PDN) may be implemented on dedicated metal layers on a backside of a die substrate or semiconductor substrate (e.g., a "backside PDN" or "buried power rail"). Such backside power delivery configuration may be thought of as "moving" power-delivering interconnects from a first side of (e.g., above) the transistors to a second side of (e.g., beneath) the transistors of a die (e.g., on an opposite side of a base semiconductor substrate (e.g., silicon wafer) on which the transistors are fabricated). In other words, data and/or signaling interconnects are positioned on one side of (e.g., above) the transistors and power interconnects are positioned on a second side of (e.g., beneath) the transistors. Stated differently, the transistors are positioned between the base semiconductor substrate (e.g., wafer) and the data and/or signally interconnected, whereas the base semiconductor substrate is positioned between the transistors and the power interconnects.

As a result of this approach, a die of an IC package can be manufactured with more data interconnects, thereby increasing data and/or signaling capabilities and/or capacity. Additionally, power interconnects positioned beneath the transistors (e.g., on the backside of a wafer) can be made larger and, therefore, less resistive. As a result, example IC packages having backside power delivery configurations provide an easier path for power to flow to a central processing unit (CPU), thereby enabling processor circuitry to experience less voltage droop and improve CPU performance. In other words, there is a smaller transient fall in voltage when demand for current increases from, for example, a large block of logic (e.g., transistors) switching on. With less voltage droop, transistors and, thus, the circuitry they implement can operate faster and/or more efficiently. Additionally, a core die can be made more compact in size, decreasing a length of interconnects between logic cells, which improves speed. For example, lack of congestion allows some of the smallest interconnects to be spaced apart or spread out, thereby reducing parasitic capacitance that hinders performance.

However, in known backside power delivery network (PDN) approaches, power switches (PWS) remain on the front side (e.g., above the transistors) while the PDN metal routing to the PWS network is established from the backside (e.g., beneath the transistors on the opposite side of the base semiconductor substrate). This is typically done because power switches employ transistors that are typically formed on the front side of the semiconductor substrate or wafer along with the transistors of the signal network or logic circuit. While the PWS is implemented using front side logic circuit or fabrication process and requires front-side routing resources for control signals, power delivered from bump(s) (e.g., VNN AON Supply) and delivered power domain (e.g., a VDD Switched Domain) are routed using the backside of the semiconductor substrate or wafer routing resources in known backside PDN implementations. To this end, dedicated power delivery mechanisms via power switches (PWS) or other integrated power delivery (IPD) provided via standard transistor logic make PWS insertion costly in terms of switching efficiency due to the reliance on front-side transistor logic process technology. Additionally, PWS placement and integration consumes chip area on the front side and, thus, reduces routing resources within front side metal layers for other purposes unrelated to controlling power states. PWS and IPD properties are dictated by the logic process technology, switching efficiency (e.g., a ratio between on- and off-state leakage current), and transistor aging/reliability effects within the constraints of the utilized front-side wafer logic technology.

Example semiconductor dies and/or integrated circuit packages disclosed herein provide power switches PWS and/or power wires, interconnects, etc., associated with a power switch or power delivery network on a backside area or layer of a semiconductor substrate (e.g., a wafer). As a result, an area of a front side of a semiconductor substrate or wafer that traditionally was used for the power switch and/or power delivery network is freed for other use (e.g., for logic circuitry, logic transistors, and/or signal circuitry). In some examples, a dedicated metal oxide semiconductor (MOS) (NMOS or PMOS) process is implemented during backside wafer processing independently from frontside wafer processing. Therefore, dedicated metal oxide semiconductor (MOS) (NMOS or PMOS) transistors and/or the power switches can be employed to improve switching efficiency associated with the power delivery network independently of the signal network and/or logic circuitry provided on the front side of the semiconductor substrate. Furthermore, transistors of the logic circuit on a front side of the semiconductor substrate can be different types of transistors and/or include aspect ratios that are different from transistors defining the power switches and/or other power delivery network components on the backside of the semiconductor substrate.

Example semiconductor dies and/or integrated circuit packages disclosed herein: (1) improve front side area consumption because routing resources for PWS or IPD insertion are not present on the front side process wafer; (2) improve (e.g., optimize) switching efficiency due to dedicated (e.g., independent) power delivery network transistor fabrication and/or manufacturing on the backside of the wafer; and (3) improve aging/reliability characteristics and/or costs for power delivery. Furthermore, examples disclosed herein provide: (1) simplification of PDN via dedicated process options; and (2) simplification of pre-silicon (Si) verification of power drop (IR) goals.

Additionally, example semiconductor dies and/or integrated packages disclosed herein facilitate and/or provide flexibility during fabrication. For example, when both the PWS/IPD logic and routing integration are on the backside of the substrate or wafer (e.g., backside process wafer), the front side of the wafer or substrate formerly consumed by PWS, PDN, and/or control signals is available for compute logic circuitry and/or other circuitry. For example, the front side of the substrate or wafer can be used for higher density logic implementations. Depending on a voltage regulator implementation approach used in a product platform (e.g., depending on the electronic device), PWS control inputs can be routed on a front side of the substrate and/or wafer. Alternatively, in some examples, depending on the features supported by a backside of a substrate or wafer (e.g., backside wafer process), implementation of voltage regulators can be provided alongside the power switches on the backside of the substrate and/or wafer and would eliminate the need of dedicated signal routing for power state control on the front side of the substrate and/or wafer (e.g., front side wafer process). Providing the dedicated signal routing for power state control on the backside of the substrate and/or wafer enables all transistor and routing resources associated with power delivery to be moved to the backside of the substrate and/or wafer.

In some examples, during fabrication, since a backside wafer process (e.g., MOS wafer process, Si MOS wafer process, GaN power transistors, etc.) is independent of the front side logic process, the underlying backside PWS and PDN can be configured (e.g., optimized) independently from the front side logic process. Since area for PWS implementation is not limited on the backside wafer, PWS can be fabricated with larger transistor geometries (e.g., planar or early generation finfet). As a result, several process features that are no longer possible (or only feasible in a very limited fashion) in gate-all-around (GAA) or complementary field-effect transistor (CFET) technologies can be enabled. Among these, improvements on PWS conductance and switching ratio can be improved (e.g., optimized). Furthermore, bi-polar transistors and diodes would be feasible for the backside wafer process, leading to improvements in on-chip electrostatic discharge (ESD) and latch up (LU) protection. Due to relaxed process geometries on the backside wafer technology, higher voltage operating ranges can be realized, which can ease platform integration and lead to improved efficiency or thermal performance. Furthermore, with the proposed de-coupling of power deliver and compute logic, non-silicon (non-Si) based materials can be used during the fabrication process (e.g., the front side wafer process and/or the backside wafer process). Some example non-silicon based materials can include, but not limited to, gallium-nitride (GaN) or other types of semiconductors including for example, aluminum gallium arsenide, indium gallium arsenide, indium gallium phosphide, boron, thallium, etc. (i.e., class/group III-V). In some examples, non-Si based materials can included, but not limited to, carbon nanotubes, antimonides and bismuthides, metal-oxides (e.g., hafnium dioxide), phase-change materials (e.g., chalcogens), magnetic materials (e.g., cobalt or iron), and/or ferroelectric materials (e.g., barium titanate), a combination therefore, and/or any other suitable material(s).

Example semiconductor dies or chiplets (e.g., tiles) disclosed herein can implement controllers, microprocessors, Digital Signal Processors (DSPs), Central Processor Units (CPUs), Graphics Processor Units (GPUs), programmed microprocessors, Field Programmable Gate Arrays (FPGAs), Application Specific Integrated Circuits (ASICs), Reduced Instruction Set Computers (RISCs), any other circuitry and/or combinations thereof. Additionally, example IC packages disclosed herein can be used with chiplets of a disaggregated die. Each chiplet (also referred to as a tile) may implement a dedicated function. Together, the chiplets may implement a complex circuitry. The complex circuitry can be any type of device that can be implemented as a plurality of chiplets that are physically separated from, but communicatively coupled to, one another. For example, processor circuitry may be implemented by two or more separate chiplets that together implement a microprocessor, etc. Alternatively, in other examples, example IC packages disclosed herein may be different chips (e.g., a processor circuitry, a memory, and/or or some other type of component) that together implement a system on a chip (SoC) in a semiconductor package.

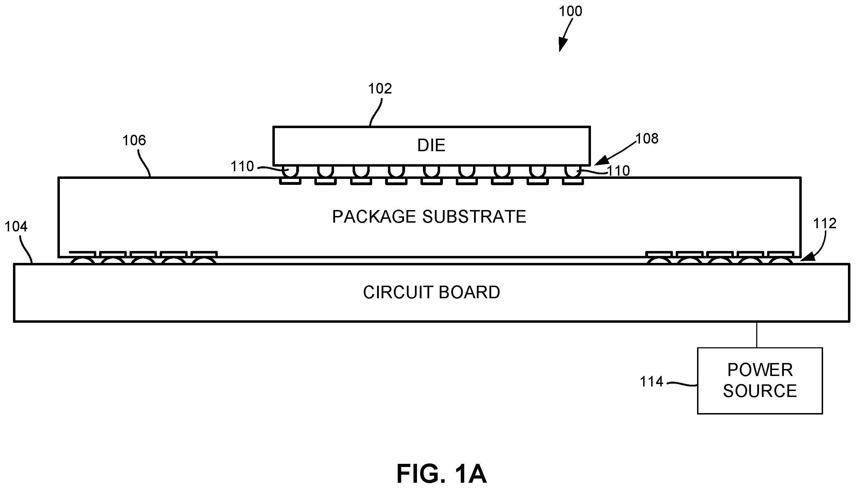

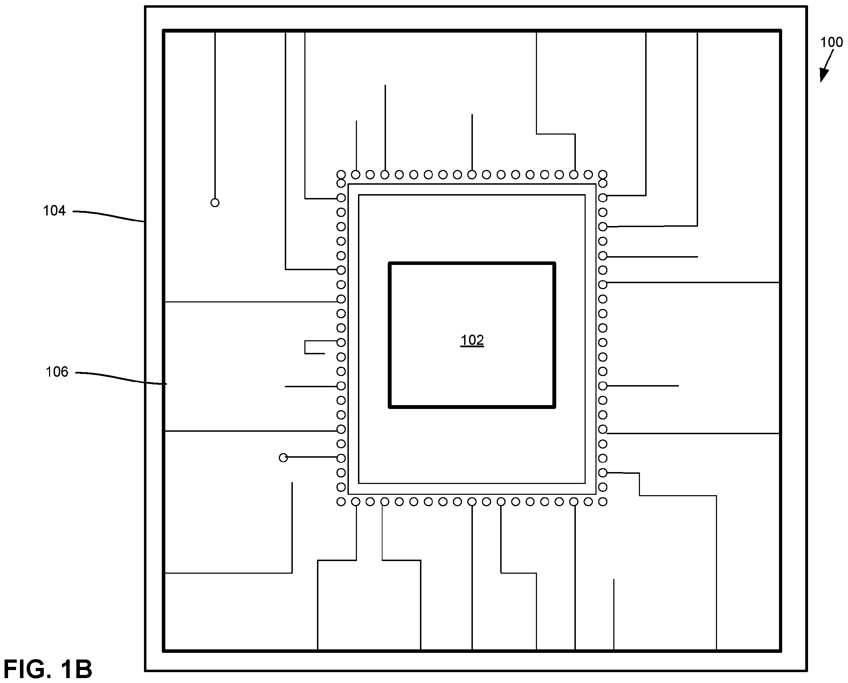

FIG. 1A illustrates an example integrated circuit (IC) package 100 (e.g., a semiconductor package, a package stack-up, etc.) including a semiconductor die 102 constructed in accordance with teachings disclosed herein. FIG. 1B is a top view of the IC package 100 of FIG. 1A. In the illustrated example, the IC package 100 is electrically coupled to a circuit board 104. The IC package 100 of the illustrated example includes the semiconductor die 102 (e.g., silicon dies, chips or chiplets, etc.) coupled (e.g., mounted) to a package substrate 106. The semiconductor die 102 can provide any suitable type of functionality (e.g., data processing, memory storage, etc.). In some examples, the semiconductor die 102 can be enclosed by a package lid or mold compound. In the illustrated example, the semiconductor die 102 is electrically and mechanically coupled to the package substrate 106 via corresponding array of interconnects 108. In FIG. 1A, the interconnects 108 are shown as bumps 110 (e.g., core bumps). In other examples, the interconnects 108 may be any other type of electrical connection in addition to or instead of the bumps 110 shown (e.g., balls, pins, pads, wire bonding, etc.). The electrical connection between the semiconductor die 102 and the package substrate 106 (e.g., via the interconnects 108) is sometimes referred to as first level interconnects. The first level interconnects establish communication and/or electrical paths between the semiconductor die 102 and the package substrate 106. The electrical connections between the IC package 100 and the circuit board 104 is provided by interconnects 112, which are sometimes referred to as second level interconnects. The second level interconnects establish communication and/or electrical paths between the circuit board 104 and the package substrate 106 (e.g., and/or the semiconductor die 102 via the package substrate 106). Specifically, the package substrate 106 and/or the IC package 100 can couple to a socket or electoral pads of the circuit board 104 via second contact pads. The socket can be a ball grid array (BGA) socket, a land grid array (LGA) socket, a pin grid array (PGA) socket, and/or any other type of socket(s) or connector(s). A power source 114 (e.g., power supply, a battery, etc.) is coupled to the circuit board 104 via (e.g., one or more traces or wires coupled to) the second level interconnects. The first level interconnects are electrically coupled to the second level interconnects by one or more traces and/or vias formed in the package substrate 106. Power is transferred from the power source 114 to the semiconductor die 102 via the first and second level interconnects.

While the example IC package 100 of FIG. 1 includes a single die, in other examples, the IC package 100 may have two or more dies. In some examples, the IC package 100 can include another die operatively and/or electrically coupled to the die via, for example, a bridge bump. For instance, bridge bumps pass electrical signals between different ones of the dies within an IC package. More particularly, bridge bumps differ from core bumps in that bridge bumps electrically connect two or more different dies via an interconnect bridge embedded in an underlying substrate (e.g., the package substrate 106). In some examples, a plurality of dies may be stacked on top of one or more other dies and/or an interposer. In such examples, the dies are coupled to the underlying die and/or interposer through a first set of first level interconnects and the underlying die and/or interposer may be connected to the package substrate 106 via a separate set of first level interconnects associated with the underlying die and/or interposer.

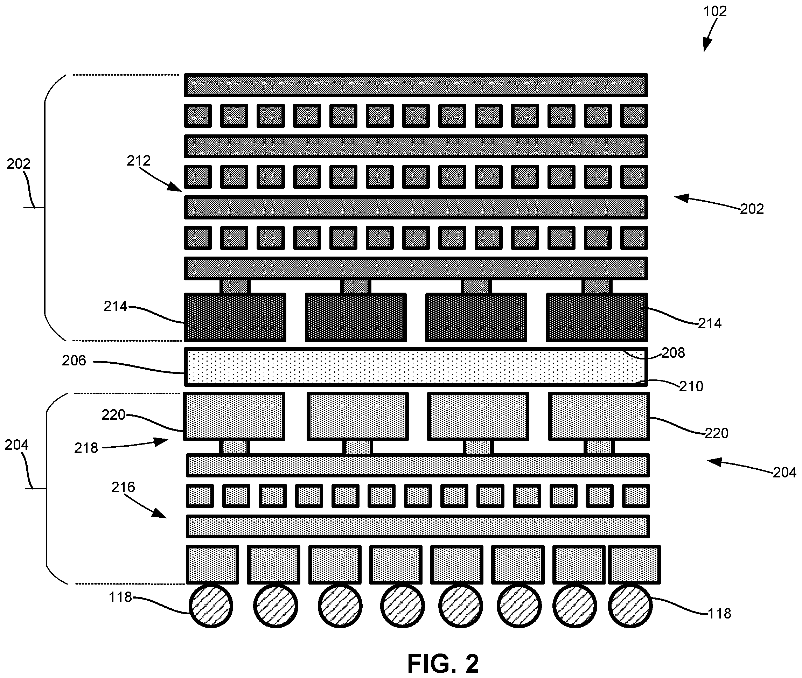

FIG. 2 is a cross-sectional view of the example semiconductor die 102 of FIG. 1. The semiconductor die 102 of the illustrated example includes backside power delivery. For example, the semiconductor die 102 of the illustrated example includes a signal network 202 and a power delivery network 204 (e.g., a backside power delivery network). For example, the semiconductor die 102 includes a die substrate 206 (e.g., provided by a silicon wafer) having a thickness defined by a first or front side 208 and a second or backside 210 opposite the front side 208. The signal network 202 is provided (e.g., formed) on the front side 208 of the die substrate 206 and the power delivery network 204 is provided (e.g., formed) on the backside 210 of the die substrate 206.

The signal network 202 of the illustrated example includes electric components (e.g., traces, vias, transistors, capacitors, resistors, thyristors, etc.) and first or front side metal layers 212 for electrically and/or communicatively coupling the components for establishing the signal network 202 (e.g., a logic network) of the semiconductor die 102. For instance, the signal network 202 of the illustrated example includes a plurality of first transistors 214 (e.g., p-type metal oxide semiconductor (PMOS) transistors, n-type metal oxide semiconductor (NMOS) transistors, etc.). The first transistors 214 are positioned between first or front side metal layers 212 and the die substrate 206. The front side metal layers 212 provide signal traces (e.g., signaling lines) to transfer signals or information between the first transistors 214 of the signal network and various components or circuitry (e.g., capacitors, resistors, backend layers, etc. and/or other circuitry) of the IC package 100, the package substrate 106 (FIG. 1A) and/or the circuit board 104 (FIG. 1A). The front side metal layers 212 include a plurality of electrically conductive and dielectric layers (e.g., alternating layers) that include traces and/or vias for transferring signals throughout the semiconductor die 102. Example dielectric material(s) can include, but not limited to, silicon dioxide (silica), titanium dioxide (TiO₂), hafnium dioxide (HfOz), hafnium zirconium oxide (HZO) (e.g., HZO film), and/or any other suitable dielectric material(s) (e.g., non-conducting material(s) that stores electrical charges). Example conductive material(s) include, but not limited to, copper, aluminum, gold, and/or any other electrically conductive material that can carry or enable passage of electrical current.

The power delivery network 204 of the illustrated example includes electrical components (e.g., traces, vias, transistors, capacitors, resistors, thyristors, etc.) and second or backside metal layers 216 for electrically and/or communicatively coupling the components of the power delivery network 204 for establishing the power delivery system of the semiconductor die 102. For example, the power delivery network 204 of the illustrated example includes a plurality of power switches 218 having a plurality of second transistors 220 (e.g., metal-oxide semiconductor field-effect transistors (MOSFET), bipolar junction transistors (BJT), insulated-gate bipolar transistors (IGBT), etc.) positioned between the backside metal layers 216 and the die substrate 206. The backside metal layers 216 provide traces that define power traces for transferring or carrying power to the IC package 100, including, for example, the first transistors 214, the second transistors 220 of the power switches 218 and other various components (e.g., capacitors, resistors, backend layers, etc. and/or other circuitry). The backside metal layers 216 are a plurality of metal and dielectric alternating layers that include traces and/or vias for providing power to the power switches 218, the front side metal layers 212 (e.g., through vias and/or traces formed in the die substrate), and/or other circuitry of the semiconductor die 102.

Thus, in the illustrated example the front side metal layers 212 are provided on the front side 208 of the die substrate 206 and the backside metal layers 216 provided on the backside 210 of the die substrate 206. The die substrate 206 includes traces and/or vias (e.g., through silicon vias (TSVs)) for electrically coupling the front side metal layers 212 and the backside metal layers 216. Additionally, the signal network 202 (e.g. provided on the front side 208) is decoupled or separated from the power delivery network 204 (e.g., provided on the backside 210). The front side metal layers 212 provide data and/or signaling communication with the first transistors 214, and the backside metal layers 216 provide power and/or control signals to the second transistors 220, the first transistors 214 and/or other components on the front side 208 of the die substrate 206. In comparison to known IC packages, the IC package 100 of the illustrated example employs the power switches 218 on the backside 210 of the die substrate 206. The power switches 218 control the operation of the first transistors 214 (e.g., provides signals or power for turning on and off the first transistors 214 provided on the front side 208 of the die substrate 206). To this end, because the first transistors 214 of the signal network 202 are provided on the front side 208 of the die substrate 206 and the second transistors 220 of the power switches 218 are provided on the backside 210 of the die substrate 206, the first transistors 214 of the signal network 202 can be different types of transistors (e.g., MOSFET transistors) than the second transistors 220 (e.g., IGFET) of the power switches 218. Additionally or alternatively, the first transistors 214 of the signal network 202 can be made with an aspect ratio (e.g., a height-to-width ratio) that is different than an aspect ratio of the second transistors 220 of the power switches 218. The aspect ratio of a transistor affects its performance, power consumption, and reliability. For example, a higher aspect ratio can improve the current drive and reduce the parasitic capacitance, but it can also increase stress and strain on the transistor, which can lead to degradation and failure. As a result of separating the first transistors 214 from the second transistors 220 by providing the first transistors 214 of the signal network 202 on the front side 208 and the second transistors 220 of the power switches 218 on the backside 210, the aspect ratios, types, and/or other characteristics of the first transistors 214 of the signal network 202 can be tailored (e.g., optimized) separately or independently from the aspect ratios, types, and/or other characteristics of the second transistors 220 of the power delivery network 204 or power switches 218. Additionally, placement and integration of the power switches 218 on the backside 210 of the die substrate 206 relieves chip area congestion on the front side 208 of the die substrate 206, enabling placement of a greater number of first transistors 214 for the signal network 202 or logic process. Such optimization can significantly improve manufacturing and/or performance of the semiconductor die 102.

In operation, power from the power source 114 is provided to the circuit board 104 and distributed to the package substrate 106 via the second level interconnects and the semiconductor die 102 via the first level interconnects, which is then distributed to one or more components (e.g., transistors, capacitors, resistors, etc.) of the semiconductor die 102 via a plurality of interconnects (e.g., metal layers, traces and/or vias) provided in the semiconductor die 102. In the illustrated example, the interconnects 108 couple the backside metal layers 216 of the semiconductor die 102 and the package substrate 106. However, in some examples, the front side metal layer 212 can include interconnects (e.g., the interconnects 118) for coupling the semiconductor die 102 and the package substrate 106 instead of the backside metal layer.

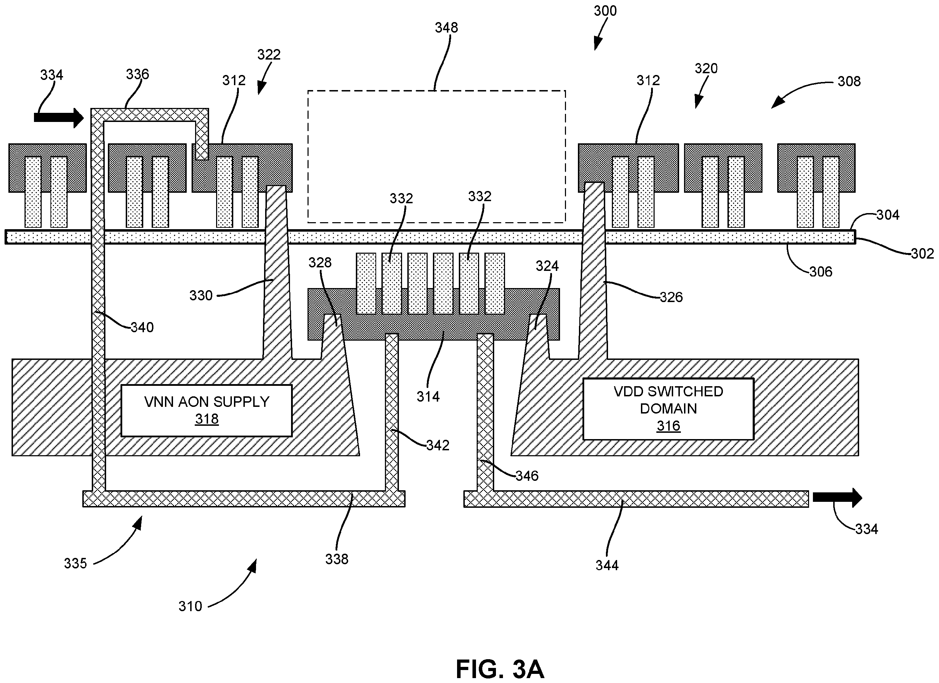

FIG. 3A is a schematic illustration of an example semiconductor die 300 disclosed herein that can implement the example semiconductor die 102 of FIGS. 1A, 1B and 2. The semiconductor die 300 of the illustrated example includes a die substrate 302 (e.g., a singulated die from a silicon wafer) defining a first or front side 304 of the die substrate 302 and a second or backside 306 of the die substrate 302. The semiconductor die 300 of the illustrated example includes a signal network 308 provided on the front side 304 of the die substrate 302 and a power delivery network 310 provided on the backside 306 of the die substrate 302. The signal network 308 of the illustrated example includes a plurality of transistors 312 associated with circuitry providing one or more logic architectures. The transistors 312 of the signal network 308 can be one or more metal-oxide-semiconductor field-effect transistors (MOSFET) (e.g., p-channel type, n-channel type, etc.) and/or any other types of transistors.

The power delivery network 310 includes a plurality of components including a power switch 314, a first power domain 316 (e.g., Vdd switched domain, a first voltage source), and a second power domain 318 (e.g., Vnn AON domain, a second voltage source). The first power domain 316 is a switched domain (e.g., Vdd switched domain) and the second power domain 318 is a non-switched or a power on domain (e.g., Vnn AON domain, always on domain). The switched domain (Vdd) refers to a power supply voltage that can be switched on and off via the power switch 314 depending on a mode of operation of an electronic device. For example, a first set 320 of the transistors 312 electrically coupled to the first power domain 316 can supply a core or central processing unit and/or one or more digital peripherals of an electronic device. For example, the first power domain 316 can turn off the first set 320 of transistors 312 via the power switch 314 when an electronic device enters a low-power mode, such as standby, sleep or shutdown, to reduce power consumption. The second power domain 318 (e.g., Vnn AON supply) provides power management to a second set 322 of the transistors 312 of the signal network 308. The second power domain 318 provides power supply voltage that is always on so long as an associated electronic device is powered (e.g., even when the electronic device is in a low-power mode, sleep mode, etc.). For example, the second power domain 318 can provide power to a backup domain including, for example, a real-time clock, backup registers, backup static random-access memory (SRAM), etc. The second power domain 318 enables an electronic device to retain some data and functionality when a main power supply is turned off. The first power domain 316 and the second power domain 318 can vary depending on a design and application of an electronic device in which the semiconductor die 300 is implemented.

The first power domain 316 and the second power domain 318 are formed in the backside metal layers of the semiconductor die 300. The first power domain 316 includes a first via 324 communicatively coupled to the power switch 314 (e.g., a gate of a transistor of the power switch 314) and a second via 326 communicatively coupled to one or more of the first set 320 of the transistors 312 of the signal network 308. Specifically, the second via 326 is communicatively coupled to one or more (e.g., gates) of the first set 320 of the transistors 312. Likewise, the second power domain 318 of the illustrated example includes a third via 328 communicatively coupled to (e.g., a gate of a transistor of) the power switch 314 and a fourth via 330 communicatively coupled to one or more (e.g., gates) of the second set 322 of the transistors 312 of the signal network 308. Thus, the second via 326 and the fourth via 330 of the illustrated example are through silicon vias (TSVs) that extend through the die substrate 302 between the backside 306 of the die substrate 302 and the front side 304 of the die substrate 302 to communicatively couple the first power domain 316 and the second power domain 318 and one or more transistors 312 of the signal network 308 provided on the front side 304 of the die substrate 302.

The power switch 314 of the illustrated example is provided on the backside 306 of the die substrate 302. The power switch 314 of the illustrated example includes a plurality of transistors 332. Thus, the transistors 332 of the power switch 314 are provided on a side of the die substrate 302 that does not include the transistors 312 of the signal network 308 or logic network. The transistors 332 of the power switch 314 can be electrically coupled in a parallel configuration and/or a series configuration. In some examples, the transistors 332 of the power switch 314 can be one or more metal-oxide-semiconductor field-effect transistors

(MOSFET) transistors (e.g., n-channel type: n-channel enhancement, n-channel depletion; p-channel type: p-channel enhancement, p-channel depletion), tunnel field-effect (TFET) transistors, complementary metal-oxide-semiconductor (CMOS) transistors, bipolar junction (BJT) transistors, insulated gate bipolar (IGBT) transistors, any combination of transistors, and/or any other transistor(s). The power switch 314 of the illustrated example is provided (e.g., formed) on the backside 306 of the die substrate 302. In other words, the power switch 314 is provided on the backside 306 of the die substrate 302 along with the backside metal layers of the semiconductor die 102.

A power switch control signal 334 (e.g., a power switch control input) is provided to the power switch 314. The power switch control signal 334 of the illustrated example is provided by the front metal layers and backside metal layers of the semiconductor die 102. In the illustrated example, the power switch control signal 334 includes a power switch control signal path 335 including first trace 336 provided on the front side 304 (e.g., the front side metal layers 212) of the die substrate 302 and a second trace 338 provided on the backside 306 (e.g., the backside metal layers 216) of the die substrate 302 that are coupled by a fifth via 340 (e.g., a through silicon via) extending through the front side 304 (e.g., the front side metal layers 212), the die substrate 302 and the backside 306 (e.g., the backside metal layers 216). A sixth via 342 formed on the backside 306 of the die substrate 302 (e.g., the backside metal layers 216) electrically couples the first trace 336 and the power switch 314. The power switch control signal 334 of the illustrated example can be provided (e.g., daisy chained) to other power switch associated with the power delivery network 310 by electrically or communicatively coupling the power switch 314 to other power switches (e.g., one or more of the power switches 218 of FIG. 2) via traces 344 and vias 346 provided in the backside 306 (e.g., the backside metal layers 216) of the semiconductor die 300.

As a result, other than the power signal traces and/or path (e.g., traces and/or vias) for providing the power switch control signal 334 to the power switch 314, all of the components (e.g., traces, power switches, transistors, capacitors, diodes, thyristors, etc.) associated with the power delivery network 310 are provided (e.g., formed) by the backside 306 of the die substrate 302 (e.g., the backside metal layers) and separate from the components of the signal network 308 provided (e.g., formed) by the front side 304 of the semiconductor die 300 (e.g., the front side metal layers). As a result, the transistors 312 of the signal network 308 and/or the transistors 312 provided on the front side 304 of the die substrate 302 and the transistors 332 of the power switch 314 and/or the transistors 332 provided by the backside 306 of the die substrate 302 can be fabricated separately during manufacturing of the semiconductor die 102. For example, an area 348 of the front side 304 represented by a dashed-line rectangle in FIG. 3A is an area that can be used by the signal network 308 that would otherwise have been occupied or taken up by the power switch 314. Thus, the example power switch 314 and/or the semiconductor die 300 of the illustrated example alleviates an area of the front side 304 that can be used by the signal network 308 (e.g., instead of the power delivery network 310). To this end, the transistors 312 of the signal network 308 can be a first type of transistor (e.g., MOSFET transistors) and the transistors 332 of the power switch 314 can be a second type of transistor (e.g., IGFET transistors) different from the first type. Additionally or alternatively, the transistors 312 of the signal network 308 can have an aspect ratio that is different than an aspect ratio or size of the transistors 332 of the power switch 314 and/or the power delivery network 310. Such configuration can significantly improve manufacturing and/or performance of the die and, thus, an electronic device. In FIG. 3A, voltage regulators are implemented on the front side 304 of the die substrate 302, resulting in a signal propagation to the backside 306 of the die substrate 302.

In operation, the power switch 314 controls power or communication between the first power domain 316 (e.g., the Vdd switched domain or power supply) and the first set 320 of the transistors 312 of the signal network 308 based on the power switch control signal 334. When a power switch control signal (e.g., an control input) is not provided to (e.g., a gate of) the transistors 332 of the power switch 314 via the power signal path, power is not provided to the first set 320 of the transistors 312 (e.g., current does not flow from the first power domain 316 through the power switch and, thus, to the first set 320 of the transistors 312 of the signal network 308 associated with (e.g., electrically coupled with) the power switch 314). Thus, the first set 320 of the transistors 312 of the signal network 308 are turned off. When a power signal is provided to (e.g., the gate of) one or more transistors 332 of the power switch 314, power is provided to the first set 320 of the transistors 312 (e.g., current flows through (e.g., a drain of) the transistors 332 of the power switch 314 and to the first set 320 of the transistors 312 of the signal network 308 associated with the power switch 314). Thus, the transistors 312 of the signal network 308 and/or the power switch 314 are configured to be normally turned off. However, in other examples, the transistors 312 of the signal network 308 and/or the power switch 314 can be configured to be normally turned on.

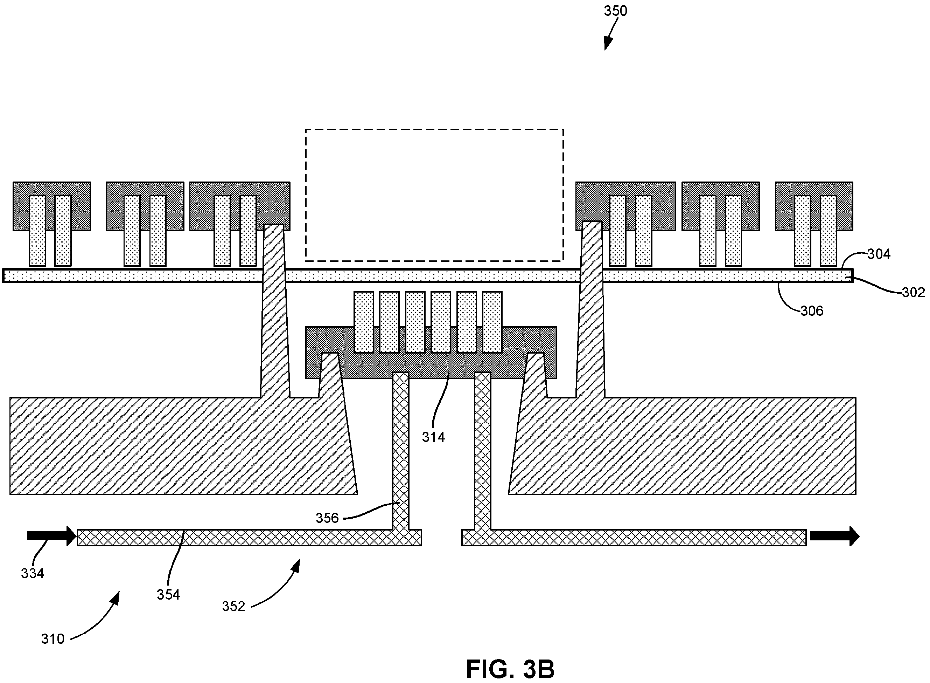

FIG. 3B is a schematic illustration of another example semiconductor die 350 disclosed herein that can implement the example semiconductor die 102 of FIGS. 1A, 1B and 2. Many of the components of the example semiconductor die 350 of FIG. 3B are substantially similar or identical to the components described above in connection with FIG. 3A. As such, those components will not be described in detail again below. Instead, the interested reader is referred to the above corresponding descriptions for a complete written description of the structure and operation of such components. To facilitate this process, similar or identical reference numbers will be used for like structures in FIG. 3B as used in FIG. 3A. The semiconductor die 350 of the illustrated example is substantially the same as the semiconductor die 300 of FIG. 3A except that voltage regulators are implemented on a back side 306 of the die substrate 302, thus, there is no need for a signal propagation on the front side 304 of the die substrate 302. As a result, a power switch control signal path 352 for a power switch 314 of the semiconductor die 350 is provided on a backside 306 (e.g., the backside metal layers) of the semiconductor die 350. In this manner, no portions (e.g., traces or vias) of the power switch control signal path 352 are needed to be provided by a front side 304 (e.g., front side metal layers) of the semiconductor die 350. In other words, the fifth via 340 and the first trace 336 of FIG. 3A can be eliminated or removed. The power switch control signal 334 is provided to the power switch 314 by a trace 354 (e.g., the second trace 338 of FIG. 3A) and a via 356 (e.g., the sixth via 342 of FIG. 3A) provided by the backside 306 (e.g., the backside metal layers). To this end, the power delivery network 310 is formed entirely or completely on the backside 306 (e.g., backside metal layers) of the die substrate 302.. Thus, the power delivery network 310 is completely or entirely provided by the backside 306 of the die substrate 302 (e.g., the backside metal layers) and completely separated or isolated from the signal network components formed on the front side 304 of the die substrate 302.

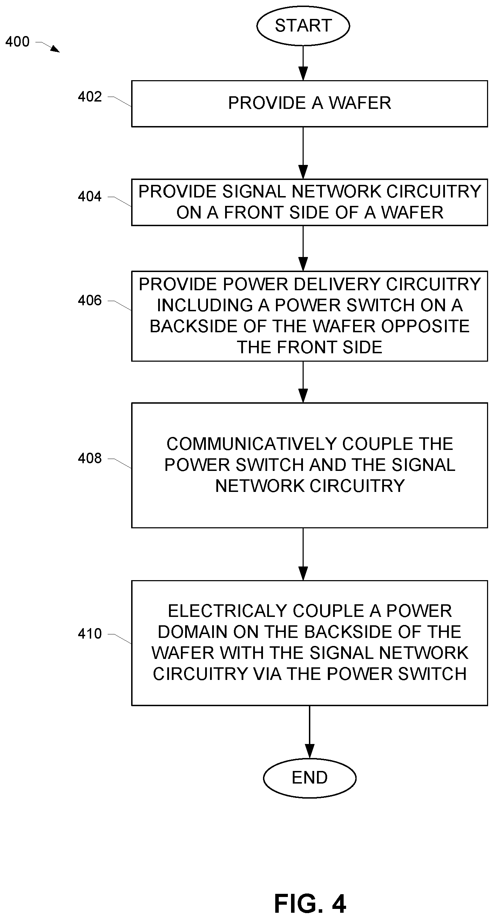

FIG. 4 is an example method 400 of fabricating a semiconductor die disclosed herein. For example, the method 400 can be employed to fabricate the semiconductor dies 102, 300 and 350 disclosed herein. The example method begins at block 402 by providing a wafer (e.g., a silicon wafer). After formation of the wafer, signal network or logic circuity of a signal network is provided on a front side of the wafer (block 404). For example, the logic circuity of the signal network (e.g., the signal network 202, 308) includes one or more electrical components including, for example, a plurality of first transistors (e.g., the transistors 214, 312), traces, interconnects, capacitors, diodes, resistors, and/or other electronical components of an electrical circuit provided on the first side (e.g., the front side 208, 304) of the wafer and/or front side metal layers (e.g., the front side metal layers 212) of the semiconductor die.

After formation of the signal network (e.g., first metal layers), a power delivery network including power switch is provided on a backside of the wafer opposite the front side (block 406). For example, the power delivery network (e.g., the power delivery network 204, 310) includes logic circuity includes one or more electrical components including, for example, second transistors (e.g., the transistors 220, 332), traces, power signal lines, capacitors, diodes, resistors and/or other electrical components of a power delivery circuitry provided on the second side (e.g., the backside 210, 306) of the wafer opposite the first side and/or backside metal layers (e.g., the backside metal layers 216) of the semiconductor die. Specifically, the second transistors pertain to power switches (e.g., the power switches 218, the power switch 314).

The power switches and/or the second transistors are communicatively coupled to the logic circuitry on the front side of the wafer (block 408). For example, the second transistors of the power switches are configured to operate the first transistors. For example, power signal traces (e.g., the power switch control signal path 335, 352) are formed in communication with the power switches, and the power switches are configured to operate (e.g., control power or current flow to) the first transistors.

Lastly, a switched power domain from the backside of the wafer is electrically coupled with the logic circuitry via the power switch (block 410). For example, one or more vias (e.g., the vias 324, 326) are provided to establish an electrical communication path between the power switch and a switched power domain (e.g., the first power domain 316) on the second side of the wafer and the first transistors on the first side of the wafer. The power control signal (e.g., the power switch control signal 334) is provided to the power switch to enable or restrict power or current flow to the logic circuitry via the power switch and the one or more vias.

The method 400 of fabricating the semiconductor die 102, 300, 350 and the semiconductor described in FIG.4 can include any semiconductor manufacturing processes and/or techniques. For example, a semiconductor die (e.g., the wafer, the first metal layers and the second metal layers) disclosed herein can be fabricated via processes including, for example, but not limited to, oxidation, lithography, etching, doping, metallization and interconnects, and polishing. The front side metal layers including the first transistors can be fabricated first, and then the backside metal layers including the second transistors can be fabricated after fabrication of the front side metal layers. In some examples, the backside metal layers and/or transistors of the power switches can be fabricated first and then the front side metal layers and/or the transistors of the signal network can be fabricated second.

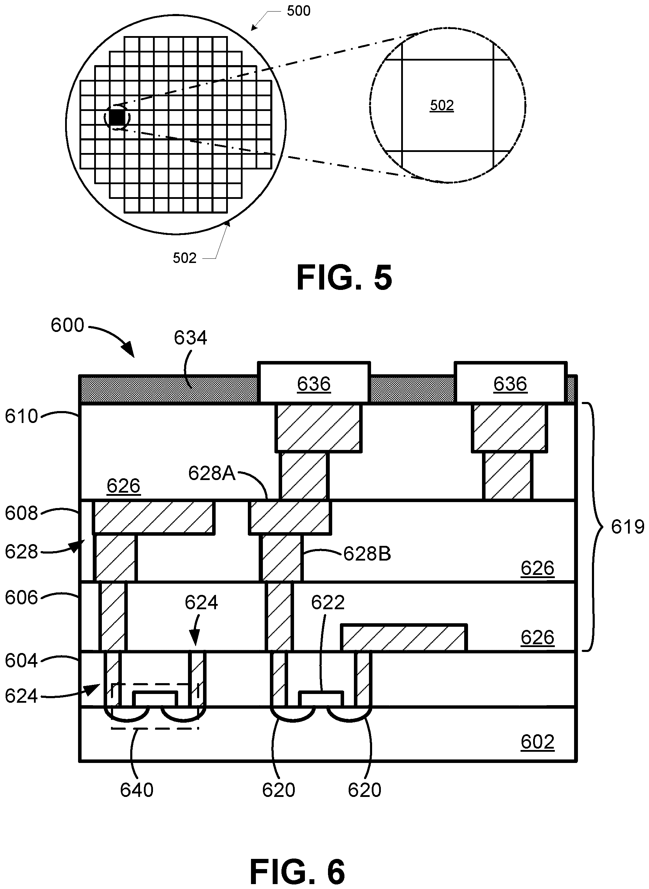

The example IC package 100 and/or example semiconductor dies 102, 300, 350 of FIGS. 1-3B disclosed herein may be included in any suitable electronic component. FIGS. 5-8 illustrate various examples of apparatus that may include or be included in the example IC package 100 and/or example semiconductor dies 102, 300, 350 disclosed herein.

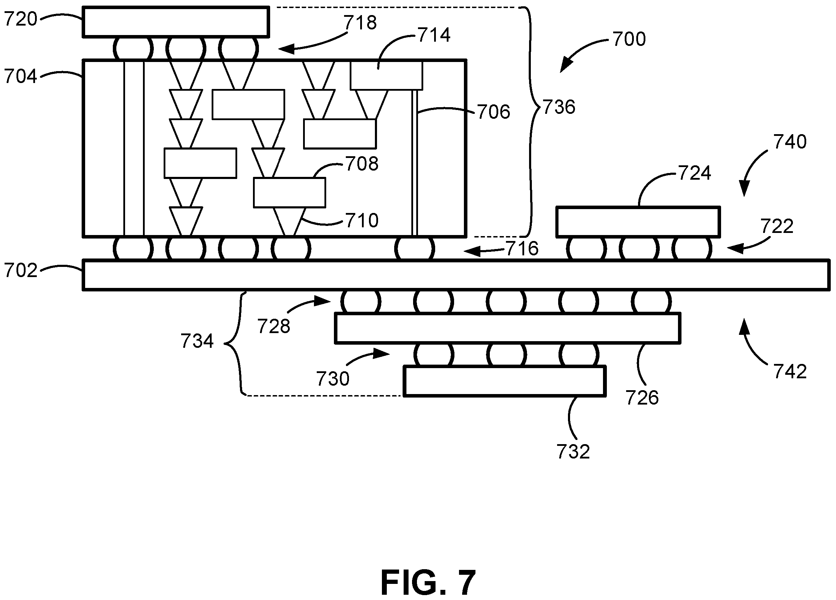

FIG. 5 is a top view of a wafer 500 and dies 502 that may be included in an IC package whose substrate includes one or more dies 102, 300, 350 (e.g., as discussed below with reference to FIG. 7) in accordance with any of the examples disclosed herein. The wafer 500 may be composed of semiconductor material and may include one or more dies 502 having circuitry. Each of the dies 502 may be a repeating unit of a semiconductor product. After the fabrication of the semiconductor product is complete, the wafer 500 may undergo a singulation process in which the dies 502 are separated from one another to provide discrete "chips." The die 502 may include one or more transistors (e.g., some of the transistors 640 of FIG. 6, discussed below), supporting circuitry to route electrical signals to the transistors, passive components (e.g., traces, resistors, capacitors, inductors, and/or other circuitry), and/or any other components. In some examples, the die 502 may include and/or implement a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuitry. Multiple ones of these devices may be combined on a single die 502. For example, a memory array formed by multiple memory circuits may be formed on a same die 502 as programmable circuitry (e.g., the processor circuitry 902 of FIG. 9) or other logic circuitry. Such memory may store information for use by the programmable circuitry. The example semiconductor dies 102, 300, 350 disclosed herein may be manufactured using a die-to-wafer assembly technique in which some dies are attached to a wafer 500 that include others of the dies, and the wafer 500 is subsequently singulated.

FIG. 6 is a cross-sectional side view of an IC device 600 that may be included in the example IC package 100 (e.g., in any one of the dies 102, 300, 350). In particular, the example IC device 600 illustrates a front side and/or front side metal layers of a die (e.g., the front side 208, 304 of the respective dies 102, 300 and/or front metal layers 212 of the dies 102, 300). The backside or backside metal layers of a die (e.g., the backside 210, 306 of the respective dies 102, 300 and/or backside metal layers 216 of the dies 102, 300) are not shown in FIG. 6. The following description of the IC device 600 applies to both the front side and/or front side metal layers and the back side and/or the back side metal layers of a die. One or more of the IC devices 600 may be included in one or more dies 502 (FIG. 5). The IC device 600 may be formed on a die substrate 602 (e.g., the wafer 500 of FIG. 5) and may be included in a die (e.g., the die 502 of FIG. 5). The die substrate 602 may be a semiconductor substrate composed of semiconductor material systems including, for example, n-type or p-type materials systems (or a combination of both). The die substrate 602 may include, for example, a crystalline substrate formed using a bulk silicon or a silicon-on-insulator (SOI) substructure. In some examples, the die substrate 602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the die substrate 602. Although a few examples of materials from which the die substrate 602 may be formed are described here, any material that may serve as a foundation for an IC device 600 may be used. The die substrate 602 may be part of a singulated die (e.g., the dies 502 of FIG. 5) or a wafer (e.g., the wafer 500 of FIG. 5). Additionally, by decoupling the fabrication of the front side wafer process (e.g. logic process) and the backside wafer process (e.g., Si MOS wafer process, or GaN power transistors), the front side wafer process can be performed independently or separately (e.g., at a different time) than the backside wafer process. In this manner, de-coupling a compute logic provided on the front side and a power delivery provided on the backside, the underlying backside power switches and/or power delivery network can be configured (e.g. optimized) independently and/or differently from the compute logic of the front side. For example, transistors associated with power delivery can be configured with larger geometries than transistors of the compute logic, transistors associated with power delivery can be configured with different aspect ratios than transistors of the compute logic, transistors associated with power delivery can be configured with different materials than transistors of the compute logic, and/or any other variation. In some examples, non-silicon based materials can be used to fabricate the front side and/or the back side of the wafer.

The IC device 600 may include one or more device layers 604 disposed on or above the die substrate 602 (e.g., a front side of the die substrate 602). The device layer 604 may include features of one or more transistors 640 (e.g., metal oxide semiconductor field-effect transistors (MOSFETs)) formed on the die substrate 602. The device layer 604 may include, for example, one or more source and/or drain (S/D) regions 620, a gate 622 to control current flow between the S/D regions 620, and one or more S/D contacts 624 to route electrical signals to/from the S/D regions 620. The transistors 640 may include additional features not depicted for the sake of clarity, such as device isolation regions, gate contacts, and the like. The transistors 640 are not limited to the type and configuration depicted in FIG. 6 and may include a wide variety of other types and/or configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 640 may include a gate 622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some examples, when viewed as a cross-section of the transistor 640 along the source-channel-drain direction, the gate electrode may consist of a U-shaped structure that includes a bottom portion substantially parallel to the surface of the die substrate 602 and two sidewall portions that are substantially perpendicular to the top surface of the die substrate 602. In other examples, at least one of the metal layers that form the gate electrode may simply be a planar layer that is substantially parallel to the top surface of the die substrate 602 and does not include sidewall portions substantially perpendicular to the top surface of the die substrate 602. In other examples, the gate electrode may consist of a combination of U-shaped structures and planar, non-U-shaped structures. For example, the gate electrode may consist of one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some examples, a plurality of spacer pairs may be used; for instance, two pairs, three pairs, or four pairs of sidewall spacers may be formed on opposing sides of the gate stack.

The S/D regions 620 may be formed within the die substrate 602 adjacent to the gate 622 of each transistor 640. The S/D regions 620 may be formed using an implantation/diffusion process or an etching/deposition process, for example. In the former process, dopants such as boron, aluminum, antimony, phosphorous, or arsenic may be ion-implanted into the die substrate 602 to form the S/D regions 620. An annealing process that activates the dopants and causes them to diffuse farther into the die substrate 602 may follow the ion-implantation process. In the latter process, the die substrate 602 may first be etched to form recesses at the locations of the S/D regions 620. An epitaxial deposition process may then be carried out to fill the recesses with material that is used to fabricate the S/D regions 620. In some implementations, the S/D regions 620 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 620 may be formed using one or more alternate semiconductor materials such as germanium or a group III-V material or alloy. In further examples, one or more layers of metal and/or metal alloys may be used to form the S/D regions 620.

Electrical signals, such as power and/or input/output (I/O) signals, may be routed to and/or from the devices (e.g., transistors 640) of the device layer 604 through one or more interconnect layers disposed on the device layer 604 (illustrated in FIG. 6 as interconnect layers 606-610). For example, electrically conductive features of the device layer 604 (e.g., the gate 622 and the S/D contacts 624) may be electrically coupled with the interconnect structures 628 of the interconnect layers 606-610. The one or more interconnect layers 606-610 may form a metallization stack (also referred to as an "ILD stack") 619 of the IC device 600.

The interconnect structures 628 may be arranged within the interconnect layers 606-610 to route electrical signals according to a wide variety of designs (in particular, the arrangement is not limited to the particular configuration of interconnect structures 628 depicted in FIG. 6). Although a particular number of interconnect layers 606-610 is depicted in FIG. 6, examples of the present disclosure include IC devices having more or fewer interconnect layers than depicted.

In some examples, the interconnect structures 628 may include lines 628a and/or vias 628b filled with an electrically conductive material such as a metal. The lines 628a may be arranged to route electrical signals in a direction of a plane that is substantially parallel with a surface of the die substrate 602 upon which the device layer 604 is formed. For example, the lines 628a may route electrical signals in a direction in and out of the page from the perspective of FIG. 6. The vias 628b may be arranged to route electrical signals in a direction of a plane that is substantially perpendicular to the surface of the die substrate 602 upon which the device layer 604 is formed. In some examples, the vias 628b may electrically couple lines 628a of different interconnect layers 606-610 together.

The interconnect layers 606-610 may include a dielectric material 626 disposed between the interconnect structures 628, as shown in FIG. 6. In some examples, the dielectric material 626 disposed between the interconnect structures 628 in different ones of the interconnect layers 606-610 may have different compositions; in other examples, the composition of the dielectric material 626 between different interconnect layers 606-610 may be the same.

A first interconnect layer 606 (referred to as Metal 1 or "M1") may be formed directly on the device layer 604. In some examples, the first interconnect layer 606 may include lines 628a and/or vias 628b, as shown. The lines 628a of the first interconnect layer 606 may be coupled with contacts (e.g., the S/D contacts 624) of the device layer 604.

A second interconnect layer 608 (referred to as Metal 2 or "M2") may be formed directly on the first interconnect layer 606. In some examples, the second interconnect layer 608 may include vias 628b to couple the lines 628a of the second interconnect layer 608 with the lines 628a of the first interconnect layer 606. Although the lines 628a and the vias 628b are structurally delineated with a line within each interconnect layer (e.g., within the second interconnect layer 608) for the sake of clarity, the lines 628a and the vias 628b may be structurally and/or materially contiguous (e.g., simultaneously filled during a dual-damascene process) in some examples.

A third interconnect layer 610 (referred to as Metal 3 or "M3") (and additional interconnect layers, as desired) may be formed in succession on the second interconnect layer 608 according to similar techniques and configurations described in connection with the second interconnect layer 608 or the first interconnect layer 606. In some examples, the interconnect layers that are "higher up" in the metallization stack 619 in the IC device 600 (i.e., further away from the device layer 604) may be thicker.

The IC device 600 may include a solder resist material 634 (e.g., polyimide or similar material) and one or more conductive contacts 636 formed on the interconnect layers 606-610. In FIG. 6, the conductive contacts 636 are illustrated as taking the form of bond pads. The conductive contacts 636 may be electrically coupled with the interconnect structures 628 and configured to route the electrical signals of the transistor(s) 640 to other external devices. For example, solder bonds may be formed on the one or more conductive contacts 636 to mechanically and/or electrically couple a chip including the IC device 600 with another component (e.g., a circuit board). The IC device 600 may include additional or alternate structures to route the electrical signals from the interconnect layers 606-610; for example, the conductive contacts 636 may include other analogous features (e.g., posts) that route the electrical signals to external components.

As noted above, a backside of the die substrate 602 can include components similar to the components of the front side of the die substrate 602. For example, the backside of the die substrate 602 can include device layers 604, interconnect layers 606, 608, 610, metallization stack 619, S/D regions 620, drain S/D regions 620, gate 622, S/D contacts 624, dielectric material 626, interconnect structure 628, couple lines 628a, vias 628b, solder resist material 634, conductive contacts 636, one or more transistors 640 (e.g., the transistors 220, 332), etc.

FIG. 7 is a cross-sectional side view of an IC device assembly 700 that may include the semiconductor dies 102, 300 and 350 and/or the IC package 100 disclosed herein. In some examples, the IC device assembly corresponds to the IC package 100. The IC device assembly 700 includes a number of components disposed on a circuit board 702 (which may be, for example, a motherboard). The IC device assembly 700 includes components disposed on a first face 740 of the circuit board 702 and an opposing second face 742 of the circuit board 702; generally, components may be disposed on one or both faces 740 and 742. Any of the IC packages discussed below with reference to the IC device assembly 700 may take the form of the example IC package 100 of FIG. 1.

In some examples, the circuit board 702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 702. In other examples, the circuit board 702 may be a non-PCB substrate.

The IC device assembly 700 illustrated in FIG. 7 includes a package-on-interposer structure 736 coupled to the first face 740 of the circuit board 702 by coupling components 716. The coupling components 716 may electrically and mechanically couple the package-on-interposer structure 736 to the circuit board 702, and may include solder balls (as shown in FIG. 7), male and female portions of a socket, an adhesive, an underfill material, and/or any other suitable electrical and/or mechanical coupling structure.

The package-on-interposer structure 736 may include an IC package 720 coupled to an interposer 704 by coupling components 718. The coupling components 718 may take any suitable form for the application, such as the forms discussed above with reference to the coupling components 716. Although a single IC package 720 is shown in FIG. 7, multiple IC packages may be coupled to the interposer 704; indeed, additional interposers may be coupled to the interposer 704. The interposer 704 may provide an intervening substrate used to bridge the circuit board 702 and the IC package 720. The IC package 720 may be or include, for example, a die (the die 502 of FIG. 5, the semiconductor die 102 of FIGS. 1A, 1B and 2, the semiconductor die 300 of FIG. 3A, the semiconductor die 350 of FIG. 3B), an IC device (e.g., the IC device 600 of FIG. 6), or any other suitable component. Generally, the interposer 704 may spread a connection to a wider pitch or reroute a connection to a different connection. For example, the interposer 704 may couple the IC package 720 (e.g., a die) to a set of BGA conductive contacts of the coupling components 716 for coupling to the circuit board 702. In the example illustrated in FIG. 7, the IC package 720 and the circuit board 702 are attached to opposing sides of the interposer 704; in other examples, the IC package 720 and the circuit board 702 may be attached to a same side of the interposer 704. In some examples, three or more components may be interconnected by way of the interposer 704.

In some examples, the interposer 704 may be formed as a PCB, including multiple metal layers separated from one another by layers of dielectric material and interconnected by electrically conductive vias. In some examples, the interposer 704 may be formed of an epoxy resin, a fiberglass-reinforced epoxy resin, an epoxy resin with inorganic fillers, a ceramic material, or a polymer material such as polyimide. In some examples, the interposer 704 may be formed of alternate rigid or flexible materials that may include the same materials described above for use in a semiconductor substrate, such as silicon, germanium, and other group III-V and group IV materials. The interposer 704 may include metal interconnects 708 and vias 710, including but not limited to through-silicon vias (TSVs) 706. The interposer 704 may further include embedded devices 714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 704. The package-on-interposer structure 736 may take the form of any of the package-on-interposer structures known in the art.

The IC device assembly 700 may include an IC package 724 coupled to the first face 740 of the circuit board 702 by coupling components 722. The coupling components 722 may take the form of any of the examples discussed above with reference to the coupling components 716, and the IC package 724 may take the form of any of the examples discussed above with reference to the IC package 720 (e.g., and/or the IC package 100)..

The IC device assembly 700 illustrated in FIG. 7 includes a package-on-package structure 734 coupled to the second face 742 of the circuit board 702 by coupling components 728. The package-on-package structure 734 may include a first IC package 726 and a second IC package 732 coupled together by coupling components 730 such that the first IC package 726 is disposed between the circuit board 702 and the second IC package 732. The coupling components 728, 730 may take the form of any of the examples of the coupling components 716 discussed above, and the IC packages 726, 732 may take the form of any of the examples of the IC package 720 discussed above. The package-on-package structure 734 may be configured in accordance with any of the package-on-package structures known in the art.

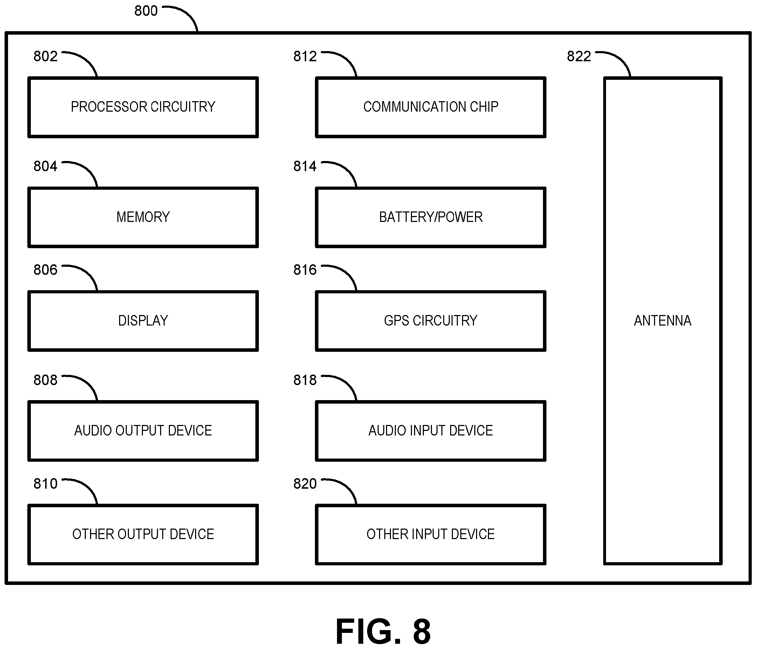

FIG. 8 is a block diagram of an example electrical device 800 that may include one or more of the example semiconductor dies 102, 300, 350 disclosed herein. For example, any suitable ones of the components of the electrical device 800 may include one or more of the device assemblies 700, IC devices 600, or dies 502 disclosed herein, and may be arranged in the example semiconductor dies 102, 300, 350 disclosed herein. A number of components are illustrated in FIG. 8 as included in the electrical device 800, but any one or more of these components may be omitted or duplicated, as suitable for the application. In some examples, some or all of the components included in the electrical device 800 may be attached to one or more motherboards. In some examples, some or all of these components are fabricated onto a single system-on-a-chip (SoC) die.

Additionally, in various examples, the electrical device 800 may not include one or more of the components illustrated in FIG. 8, but the electrical device 800 may include interface circuitry for coupling to the one or more components. For example, the electrical device 800 may not include a display 806, but may include display interface circuitry (e.g., a connector and driver circuitry) to which a display 806 may be coupled. In another set of examples, the electrical device 800 may not include an audio input device 818 (e.g., microphone) or an audio output device 808 (e.g., a speaker, a headset, earbuds, etc.), but may include audio input or output device interface circuitry (e.g., connectors and supporting circuitry) to which an audio input device 818 or audio output device 808 may be coupled.

The electrical device 800 may include programmable circuitry 802 (e.g., one or more processing devices). The programmable circuitry 802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 800 may include a memory 804, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 804 may include memory that shares a die with the programmable circuitry 802. This memory may be used as cache memory and may include embedded dynamic random access memory (eDRAM) or spin transfer torque magnetic random access memory (STT-MRAM).

In some examples, the electrical device 800 may include a communication chip 812 (e.g., one or more communication chips). For example, the communication chip 812 may be configured for managing wireless communications for the transfer of data to and from the electrical device 800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 812 may operate in accordance with other wireless protocols in other examples. The electrical device 800 may include an antenna 822 to facilitate wireless communications and/or to receive other wireless communications (such as AM or FM radio transmissions).

In some examples, the communication chip 812 may manage wired communications, such as electrical, optical, or any other suitable communication protocols (e.g., the Ethernet). As noted above, the communication chip 812 may include multiple communication chips. For instance, a first communication chip 812 may be dedicated to shorter-range wireless communications such as Wi-Fi or Bluetooth, and a second communication chip 812 may be dedicated to longer-range wireless communications such as global positioning system (GPS), EDGE, GPRS, CDMA, WiMAX, LTE, EV-DO, or others. In some examples, a first communication chip 812 may be dedicated to wireless communications, and a second communication chip 812 may be dedicated to wired communications.

The electrical device 800 may include battery/power circuitry 814. The battery/power circuitry 814 may include one or more energy storage devices (e.g., batteries or capacitors) and/or circuitry for coupling components of the electrical device 800 to an energy source separate from the electrical device 800 (e.g., AC line power).

The electrical device 800 may include a display 806 (or corresponding interface circuitry, as discussed above). The display 806 may include any visual indicators, such as a heads-up display, a computer monitor, a projector, a touchscreen display, a liquid crystal display (LCD), a light-emitting diode display, or a flat panel display.

The electrical device 800 may include an audio output device 808 (or corresponding interface circuitry, as discussed above). The audio output device 808 may include any device that generates an audible indicator, such as speakers, headsets, or earbuds.

The electrical device 800 may include an audio input device 818 (or corresponding interface circuitry, as discussed above). The audio input device 818 may include any device that generates a signal representative of a sound, such as microphones, microphone arrays, or digital instruments (e.g., instruments having a musical instrument digital interface (MIDI) output).

The electrical device 800 may include GPS circuitry 816. The GPS circuitry 816 may be in communication with a satellite-based system and may receive a location of the electrical device 800, as known in the art.

The electrical device 800 may include any other output device 810 (or corresponding interface circuitry, as discussed above). Examples of the other output device 810 may include an audio codec, a video codec, a printer, a wired or wireless transmitter for providing information to other devices, or an additional storage device.

The electrical device 800 may include any other input device 820 (or corresponding interface circuitry, as discussed above). Examples of the other input device 820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 800 may have any desired form factor, such as a hand-held or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device. In some examples, the electrical device 800 may be any other electronic device that processes data.

The foregoing examples of the IC packages 100, 720, 726, 732, the IC device assembly 700, the circuit boards 104, 702, the die substrates 206, 302, 500, the semiconductor dies 102, 300, 350, 502, and/or the die substrate 602 teach or suggest different features. Although each example IC package 100, 720, 726, 732, the IC device assembly 700, the circuit board 104, 702, the die substrate 206, 302, 500, the semiconductor dies 102, 300, 350, 502, and/or the die substrate 602 disclosed above has certain features, it should be understood that it is not necessary for a particular feature of one example to be used exclusively with that example. Instead, any of the features described above and/or depicted in the drawings can be combined with any of the examples, in addition to or in substitution for any of the other features of those examples. One example's features are not mutually exclusive to another example's features. Instead, the scope of this disclosure encompasses any combination of any of the features.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example, an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, methods, apparatus, and articles of manufacture have been disclosed that improve and/or facilitate semiconductor die efficiency and/or fabrication.

Example methods, apparatus, systems, and articles of manufacture to provide IC package apparatus are disclosed herein. Further examples and combinations thereof include the following:

Example methods, apparatus, systems, and articles of manufacture to semiconductor dies and/or IC package(s) are disclosed herein. Further examples and combinations thereof include the following:

Example 1 includes a semiconductor die including a semiconductor substrate defining a front side and a backside. A signal network is provided on the front side. The signal network includes a plurality of first transistors. A power delivery network is provided on the backside. The power delivery network includes a power switch provided on the backside. The power switch includes a plurality of second transistors. The power switch is to cause operation of the first transistors to switch between a first operating state and a second operating state.

Example 2 includes the semiconductor die of example 1, where the first transistors are fabricated on the front side separately from the second transistors.

Example 3 includes the semiconductor die of examples 1 or 2, where the first transistors are a first type of transistors and the second transistors are a second type of transistors different than the first type.

Example 4 includes the semiconductor die of examples 1-3, where the first type of transistors include metal-oxide silicon field-effect transistors (MOSFET) and the second type of transistors include bipolar junction transistors (BJT).

Example 5 includes the semiconductor die of examples 1-4, where a power signal for the power switch is provided entirely on the backside.

Example 6 includes the semiconductor die of examples 1-5, where a portion of a power signal electrically coupled to the power switch is provided on the front side of the semiconductor substrate.

Example 7 includes the semiconductor die of examples 1-6, where the second transistors of the power switch are provided entirely on the backside.

Example 8 includes the semiconductor die of examples 1-7, where no portions of the power switch are provided on the front side of the semiconductor substrate.

Example 9 includes the semiconductor die of examples 1-8, where the first operating state of the first transistors is an off state and the second operating state of the first transistors is an on state.

Example 10 includes the semiconductor die of examples 1-9, where the power switch is electrically coupled with the first transistors by one or more through silicon vias that extend through the semiconductor substrate.

Example 11 includes the semiconductor die of examples 1-10, where the first transistors include a first aspect ratio and the second transistors include a second aspect ratio different than the first aspect ratio.

Example 12 includes a die includes a bulk semiconductor layer having first metal layers provided on a first side of the bulk semiconductor layer and a plurality of first transistors between the first metal layer and the bulk semiconductor layer, where the first transistors to implement logic circuitry for the die. The bulk semiconductor layer includes second metal layers provided on a second side of the bulk semiconductor layer opposite the first side and a plurality of second transistors between the second metal layer and the bulk semiconductor layer, where the second transistors provide a power switch. A power signal trace provides a signal to the power switch. The power signal trace is to provide a first signal to cause the power switch to enable current flow to the first transistors and to provide a second signal to cause the power switch to restrict current flow to the first transistors.

Example 13 includes the die of example 12, where the first transistors include a first aspect ratio and the second transistors include a second aspect ratio different than the first aspect ratio.

Example 14 includes the die of examples 12 or 13, where the first transistors have a first aspect ratio and the second transistors have a second aspect ratio, the first aspect ratio is the same as the second aspect ratio.

Example 15 includes the die of examples 12-14, where the second transistors are electrically coupled with the first transistors by one or more vias that extend through the bulk semiconductor layer.

Example 16 includes a method for fabricating a semiconductor die, the method including providing a wafer, providing a plurality of first transistors on a first side of the wafer, the first transistors pertaining to logic circuitry, providing a plurality of second transistors on a second side of the wafer opposite the first side, the second transistors pertaining to a power switch to operate the first transistors, and providing a via to establish an electrical communication path between the power switch on the second side of the wafer and the first transistors on the second side of the wafer.

Example 17 includes the method of example 16, further including providing the first transistors with a first aspect ratio and the second transistors with a second aspect ratio different than the first aspect ratio.

Example 18 includes the method of examples 16 or 17, further including fabricating the first transistors as a first transistor type and fabricating the second transistors as a second transistor type different than the first transistors.

Example 19 includes the method of examples 16-18, further including fabricating the first transistors with a first fabrication process and fabricating the second transistors with a second fabrication processes different than the first fabrication process.

Example 20 includes the method of examples 16-19, further including fabricating the first transistors prior to fabricating the second transistors.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A semiconductor die comprising:
a semiconductor substrate defining a front side and a backside;
a signal network provided on the front side, the signal network including a plurality of first transistors; and
a power delivery network provided on the backside, the power delivery network including a power switch provided on the backside, the power switch including a plurality of second transistors, the power switch to cause operation of the first transistors to switch between a first operating state and a second operating state.

2. The semiconductor die of claim 1, wherein the first transistors are fabricated on the front side separately from the second transistors.

3. The semiconductor die of any one of claims 1 or 2, wherein the first transistors are a first type of transistors and the second transistors are a second type of transistors different than the first type.

4. The semiconductor die of any one of claims 1-3, wherein the first type of transistors include metal-oxide silicon field-effect transistors (MOSFET) and the second type of transistors include bipolar junction transistors (BJT).

5. The semiconductor die of any one of claims 1-4, wherein a power signal for the power switch is provided entirely on the backside.

6. The semiconductor die of any one of claims 1-5, wherein a portion of a power signal electrically coupled to the power switch is provided on the front side of the semiconductor substrate.

7. The semiconductor die of any one of claims 1-6, wherein the second transistors of the power switch are provided entirely on the backside.

8. The semiconductor die of any one of claims 1-7, wherein no portions of the power switch are provided on the front side of the semiconductor substrate.

9. The semiconductor die of any one of claims 1-8, wherein the first operating state of the first transistors is an off state and the second operating state of the first transistors is an on state.

10. The semiconductor die of any one of claims 1-9, wherein the power switch is electrically coupled with the first transistors by one or more through silicon vias that extend through the semiconductor substrate.

11. The semiconductor die of any one of claims 1-10, wherein the first transistors include a first aspect ratio and the second transistors include a second aspect ratio different than the first aspect ratio.

12. A method for fabricating a semiconductor die, the method comprising:
providing a wafer;
providing a plurality of first transistors on a first side of the wafer, the first transistors pertaining to logic circuitry;
providing a plurality of second transistors on a second side of the wafer opposite the first side, the second transistors pertaining to a power switch to operate the first transistors; and
providing a via to establish an electrical communication path between the power switch on the second side of the wafer and the first transistors on the second side of the wafer.

13. The method of claim 12, further including providing the first transistors with a first aspect ratio and the second transistors with a second aspect ratio different than the first aspect ratio.

14. The method of any one of claims 12-13, further including fabricating the first transistors as a first transistor type and fabricating the second transistors as a second transistor type different than the first transistors.

15. The method of any one of claims 12-14, further including fabricating the first transistors with a first fabrication process and fabricating the second transistors with a second fabrication processes different than the first fabrication process, and/or,
further including fabricating the first transistors prior to fabricating the second transistors.
